# EUROPEAN PATENT APPLICATION

(11) **EP 4 525 041 A2**
(43) Date of publication of application: **19.03.2025**
(21) Application number: 24198243.8
(22) Date of filing: 03.09.2024
(51) Int. Cl.: H01L 23/66, H01L 21/60, H01L 23/538, H01L 23/31

(54) **SEMICONDUCTOR DEVICE, WIRELESS COMMUNICATION DEVICE, AND METHOD FOR FABRICATING SEMICONDUCTOR DEVICE**

(30) Priority: 15.09.2023 JP 2023150191
(71) Applicant: FUJITSU LIMITED, Kawasaki-shi, Kanagawa 211-8588 (JP)
(72) Inventor: OZAKI, Shirou, Kawasaki-shi, 211-8588 (JP); NAKASHA, Yasuhiro, Kawasaki-shi, 211-8588 (JP); OKAMOTO, Naoya, Kawasaki-shi, 211-8588 (JP); KUMAZAKI, Yusuke, Kawasaki-shi, 211-8588 (JP); HARA, Naoki, Kawasaki-shi, 211-8588 (JP); OHKI, Toshihiro, Kawasaki-shi, 211-8588 (JP)
(74) Representative: Haseltine Lake Kempner LLP

(57) **Abstract**

[Problem]

To provide a semiconductor device in which parasitic capacitance of a semiconductor element is reduced, a radio communication device, and a method of fabricating the semiconductor device.

[Solution]

A semiconductor device (100) includes a semiconductor element (110); an interconnect layer (130) provided on a first surface side of the semiconductor element (110), the interconnect layer including an interconnect (131) connected to the semiconductor element and an insulating layer (132) covering the interconnect; and a cavity (140) provided between the first surface of the semiconductor element and the interconnect layer.

## Description

### FIELD

The disclosures discussed herein relate to a semiconductor device, a wireless communication device, and a method for fabricating the semiconductor device.

### BACKGROUND

In the related art, a semiconductor device including a redistribution layer and a photosensitive ink layer that are provided on an image sensing chip has been proposed. In such a semiconductor device, the image sensing chip has a hollow opening, the redistribution layer extends inside the hollow opening, and a cavity is provided above the redistribution layer (for example, see Japanese National Publication of International Patent Application No. 2018-533225).

### SUMMARY

In such a related art semiconductor device, an upper surface of the image sensing chip (a semiconductor element) is covered with the redistribution layer and the photosensitive ink layer, and thus the parasitic capacitance of the semiconductor element is large.

Accordingly, it appears desirable to provide a semiconductor device with reduced parasitic capacitance of a semiconductor element, a wireless communication device, and a method for fabricating the semiconductor device.

According to an aspect of an embodiment of the present disclosure, a semiconductor device includes:
a semiconductor element;
an interconnect layer provided on a first surface side of the semiconductor element, the interconnect layer including an interconnect connected to the semiconductor element and an insulating layer covering the interconnect; and
a cavity provided between the first surface of the semiconductor element and the interconnect layer.

### ADVANTAGEOUS EFFECT

The embodiment of the present disclosure can provide a semiconductor device with reduced parasitic capacitance of a semiconductor element, a wireless communication device, and a method of fabricating the semiconductor device.

The object and advantages of the invention will be realized and attained by means of the elements and combinations particularly pointed out in the claims.

It is to be understood that both the foregoing general description and the following detailed description are exemplary and explanatory and are not restrictive of the invention, as claimed.

### BRIEF DESCRIPTION OF DRAWINGS

FIG. 1 is a view illustrating an example of a cross-sectional configuration of a wireless communication device 200 including a semiconductor device 100 according to an embodiment.
FIG. 2 is a view illustrating an example of a cross-sectional configuration of the semiconductor device 100 according to the embodiment.
FIG. 3 is a view illustrating an example of a more specific cross-sectional configuration of the semiconductor device 100.
FIG. 4A is a view illustrating an example of a method for fabricating the semiconductor device 100.
FIG. 4B is a view illustrating an example of the method for fabricating the semiconductor device 100.
FIG. 4C is a view illustrating an example of the method for fabricating the semiconductor device 100.
FIG. 4D is a view illustrating an example of the method for fabricating the semiconductor device 100.
FIG. 5A is a view illustrating an example of a cross-sectional configuration of a semiconductor device 10 according to a comparative example.
FIG. 5B is a view illustrating an example of a cross-sectional configuration of the semiconductor device 100 according to the embodiment.
FIG. 5C is a graph illustrating an example of experimental results.
FIG. 6 is a view illustrating an example of a cross-sectional configuration of a semiconductor device 100A according to a modification of the embodiment.

### DESCRIPTION OF EMBODIMENTS

Hereinafter, an embodiment to which a semiconductor device, a wireless communication device, and a method for fabricating the semiconductor device according to the present disclosure are applied will be described with reference to the accompanying drawings. In the following description, the same elements are denoted by the same reference numerals, and redundant description may be omitted.

In the following description, an XYZ coordinate system is defined. A direction parallel to the X-axis (X direction), a direction parallel to the Y-axis (Y direction), and a direction parallel to the Z-axis (Z direction) are orthogonal to each other. The X direction is an example of a first axis direction, the Y direction is an example of a second axis direction, and the Z direction is an example of a third axis direction. Further, the plan view means an XY plane view.

In the following description, the length, thickness, and the like of each portion may be exaggerated to facilitate the understanding of the configuration. In addition, the terms "parallel", "perpendicular", "orthogonal", "horizontal", "vertical", "upper", "lower", and the like allow a deviation to the extent that the effect of the embodiment is not impaired.

### <Embodiment>

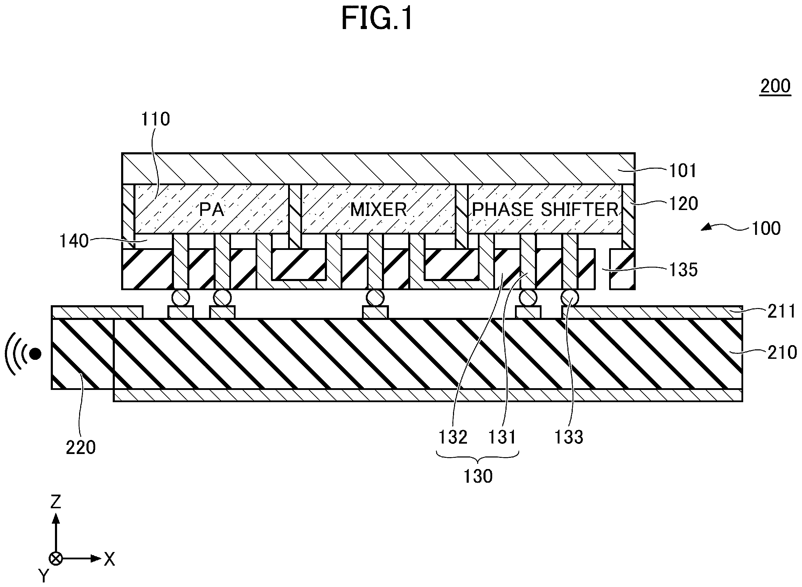

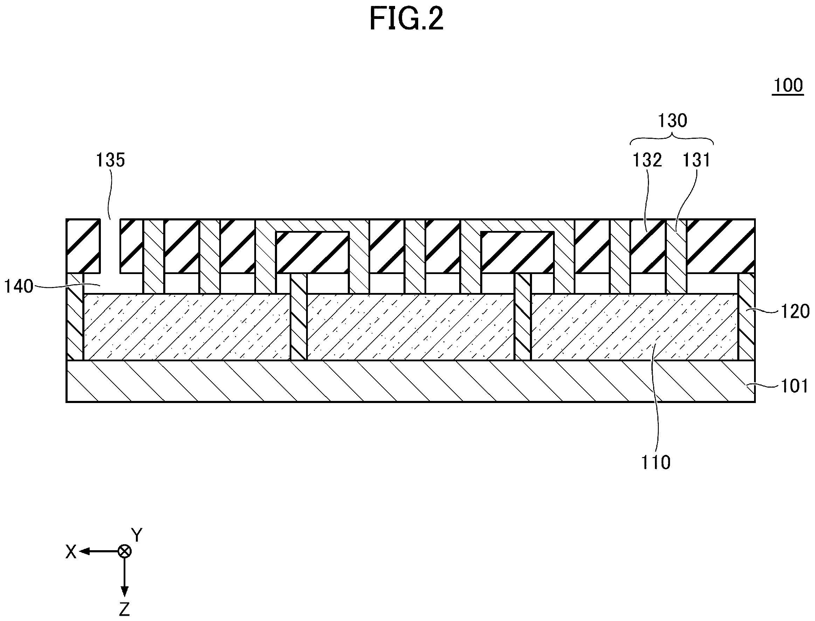

FIG. 1 is a view illustrating an example of a cross-sectional configuration of a wireless communication device 200 including a semiconductor device 100 according to an embodiment. FIG. 2 is a view illustrating an example of a cross-sectional configuration of the semiconductor device 100 according to the embodiment. In FIG. 2, the semiconductor device 100 illustrated in FIG. 1 is illustrated upside down.

The wireless communication device 200 includes the semiconductor device 100, a circuit board 210, and an antenna 220. The semiconductor device 100 includes a heat sink 101, a semiconductor element 110, a mold resin 120, a redistribution layer 130, and a cavity 140. The semiconductor device 100 is connected to an interconnect layer 211 on the surface of the circuit board 210 in the +Z direction by, for example, a bump 133 made of solder. That is, the semiconductor device 100 is flip-chip mounted on the circuit board 210. Each of the components will be described below.

### <Outline of Wireless Communication Device 200>

The circuit board 210 of the wireless communication device 200 is, for example, a high-frequency circuit board capable of transmitting signals in an ultra-high frequency band exceeding 100 GHz, and includes the interconnect layer 211 on surfaces and an inner layer on the ± Z direction sides. In addition, as an example, an antenna 220 is formed at the end of the circuit board 210 in the -X direction. The antenna 220 is connected to the semiconductor device 100 through the interconnect layer 211 of the circuit board 210. The antenna 220 is, for example, a phased array antenna having directivity in the -X direction.

FIG. 1 illustrates, as an example, a configuration in which three semiconductor elements 110 of the semiconductor device 100 are a power amplifier (PA), a mixer, and a phase shifter. The semiconductor elements 110 are not limited to the PA, the mixer, and the phase shifter. The wireless communication device 200 having such a configuration can amplify a signal by the PA, mix the signal with a local signal by the mixer, shift the phase of the signal by the phase shifter, and transmit the signal from the antenna 220. The wireless communication device 200 can receive a signal in the ultra-high frequency band. The wireless communication device 200 can be used as, for example, base stations of mobile communication systems for beyond 5G (fifth generation)/6G (sixth generation).

In a mobile communication system for Beyond 5G/6G, realization of high-speed and large-capacity communication (5G or more) that greatly exceeds 100 Gbps is required. For example, in a wireless personal area network (WPAN), which is one of the use cases, it may be expected to transmit advanced video data such as high-definition moving images or holograms exceeding 8K to individual users to perform, for example, remote medical care or remote control in factories or the like. In order to meet such expectations, an increase in transmission speed may be essential, and the use of "terahertz waves" around 300 GHz, which have a wider bandwidth than related-art microwaves or millimeter waves, may be suggested.

When utilizing these ultra-high frequency radio waves, it may be considered desirable to use, in addition to the WPAN, a phased array antenna that directs a beam only in a necessary direction for securing a reaching distance of radio waves and reducing power consumption. However, it may be challenging to secure a communication range assumed in a use case with an output of an array antenna in a 300 GHz band using a complementary metal oxide semiconductor (CMOS) or SiGe amplifier which has been reported so far. Therefore, it is expected that a communication distance is extended and directivity of radio waves is improved by using a high-power amplifier, to which a compound semiconductor such as gallium nitride (GaN) or indium phosphide (InP) is applied, to integrate these elements with an antenna to form an array.

In the ultra-high frequency band exceeding 100 GHz, it has been reported that a transmission loss of a signal in a solder or a wire bonding portion used for bonding between semiconductor elements in a front end of radio wave transmission and reception such as an amplifier, a mixer, and a phase shifter may adversely affect high-frequency characteristics of a module. As a countermeasure, a redistribution structure using a mold resin has been studied as a structure of a semiconductor device including a semiconductor element. However, when the surface of the semiconductor element is covered with the insulating layer for rewiring, the parasitic capacitance increases, and the high-frequency characteristics deteriorates. Therefore, it is desirable to lower the parasitic capacitance.

In addition, heat generation becomes severe when rewiring a high-power amplifier. Therefore, it is desirable to implement a heat dissipation structure capable of preventing warpage of a semiconductor device including a semiconductor element.

An example of a specific structure of the semiconductor device 100 will be described below. The application of the semiconductor device 100 is not limited to the mobile communication system for beyond 5G/6G as described above, but may be suitable for a wireless communication system that handles a signal in an ultra-high frequency band exceeding 100 GHz, for example.

### <Specific Configuration of Semiconductor Device 100>

### <Semiconductor Element 110>

As illustrated in FIG. 2, the semiconductor device 100 includes a plurality of semiconductor elements 110. The semiconductor element 110 is a semiconductor chip that is singulated, and may be an element including various semiconductor circuits, not limited to the PA, the mixer, and the phase shifter. The semiconductor device 100 may include at least one semiconductor element 110, and any number of semiconductor elements 110 may be used. The semiconductor element 110 is implemented by a GaN HEMT (High Electron Mobility Transistor) which is a GaN-based compound semiconductor, for example.

As an example, a single common heat sink 101 is connected to the surfaces of all the semiconductor elements 110 on the +Z direction side. The heat sink 101 is located on the semiconductor elements 110 in the state illustrated in FIG. 1, and releases heat generated by the semiconductor elements 110 into the air. The heat sink 101 is made of metal or ceramic, for example.

The side surfaces of the semiconductor elements 110 are covered with the mold resin 120. In the XZ cross-section illustrated in FIG. 2, side surfaces of the semiconductor elements 110 on the ±X direction sides are covered with the mold resin 120, but the side surfaces on the +Y direction side and/or side surfaces on the -Y direction side may also be covered with the mold resin 120. The plurality of semiconductor elements 110 are fixed by the mold resin 120.

A plurality of pads (not illustrated) are provided on the surface of the semiconductor elements 110 on the -Z direction side, and a redistribution interconnect 131 of the redistribution layer 130 is connected to each pad. The redistribution layer 130 is an example of an interconnect layer, and the redistribution interconnect 131 is an example of an interconnect. A cavity 140 is provided between all the semiconductor elements 110 and the redistribution layer 130. That is, the surfaces of all the semiconductor elements 110 on the -Z direction side are not covered with the redistribution layer 130, but are provided with the cavities 140. This configuration is to reduce the parasitic capacitance of the semiconductor element 110 and the redistribution interconnect 131.

### <Mold Resin 120>

The mold resin 120 is fixed to the side surfaces of all the semiconductor elements 110. The position of the end portion of the mold resin 120 on the +Z direction side is equal to and flush with the position of the surface of each semiconductor element 110 on the +Z direction side. The end portion of the mold resin 120 on the -Z direction side protrudes more toward the -Z direction side than the surface of the semiconductor element 110 on the -Z direction side, and supports the surface of the interlayer insulating film 132 of the redistribution layer 130 on the +Z direction side. The interlayer insulating film 132 is an example of an insulating layer. The surface of the interlayer insulating film 132 on the +Z direction side is the surface of the redistribution layer 130 on the +Z direction side. In this way, the cavity 140 is provided between the surface of the redistribution layer 130 on the +Z direction side (the surface of the interlayer insulating film 132 on the +Z direction side) and the surface of the semiconductor element 110 on the -Z direction side. In the portion of the cavity 140, the mold resin 120 supports the redistribution layer 130 with respect to the semiconductor element 110. As a material of the mold resin 120, a thermosetting resin such as an epoxy resin can be used.

### <Redistribution Layer 130>

The redistribution layer 130 includes a redistribution interconnect 131, an interlayer insulating film 132, and a through hole 135. The redistribution layer 130 is formed on the -Z direction side of the semiconductor element 110 fixed by the mold resin 120, for example. As described above, the cavity 140 is provided between the surface of the redistribution layer 130 on the +Z direction side (the surface of the interlayer insulating film 132 on the +Z direction side) and the surface of the semiconductor element 110 on the -Z direction side. The end portion of the redistribution interconnect 131 on the +Z direction side is connected to the pad of the semiconductor element 110 through the inside of the cavity 140. The redistribution interconnect 131 can be made of a metal such as copper, for example, and the interlayer insulating film 132 can be made of a photosensitive resin such as photosensitive polyimide.

The through hole 135 penetrates a portion of the interlayer insulating film 132 of the redistribution layer 130 on the -Z direction side of the cavity 140 in the Z direction to communicate with the cavity 140. The through hole 135 is provided for injecting an etching solution or the like when a sacrificial film for forming the cavity 140 is removed. The sacrificial film is removed by injecting an etching solution such as N-methyl-2-pyrrolidone (NMP) into the through hole 135 to form the cavity 140. Note that dry etching using ultraviolet light may be performed instead of the above-described wet etching. In this case, the reaction can be promoted when the redistribution layer 130 has the through hole 135, but the redistribution layer 130 may not have the through hole 135.

Note that the configuration in which the through hole 135 penetrates the portion of the interlayer insulating film 132 on the -Z direction side of the cavity 140 in the Z direction has been described here. However, the through hole 135 may penetrate a portion of the interlayer insulating film 132 other than the portion on the -Z direction side of the cavity 140. The through hole 135 may be bent in partway-through.

Although FIG. 2 illustrates one through hole 135 provided corresponding to the leftmost semiconductor element 110 of the three semiconductor elements 110, it is preferable that each semiconductor element 110 be provided with at least one through hole 135. Such a configuration enables the sacrificial film to be removed more reliably.

### <Cavity 140>

The cavity 140 is provided between the surface of the redistribution layer 130 on the +Z direction side (the surface of the interlayer insulating film 132 on the +Z direction side) and the surface of the semiconductor element 110 on the -Z direction side. Since air is present in the cavity 140, the relative dielectric constant at a portion on the surface side of the semiconductor element 110 on the -Z direction side can be reduced, compared to the case where an insulating material such as the interlayer insulating film 132 is present in place of the cavity. Thereby, the parasitic capacitance at the portion on the surface side of the semiconductor element 110 on the -Z direction side and at the redistribution interconnect 131 can be reduced.

The cavity 140 is divided in the X direction by the mold resin 120, and each semiconductor element 110 is provided with one cavity 140. This configuration enables both securing the strength of the redistribution layer 130 and reducing the parasitic capacitance. In the configuration in which each semiconductor element 110 is provided with one cavity 140, each cavity 140 is preferably provided with one through hole 135. This configuration enables the sacrificial film to be removed more reliably.

In FIG. 2, the relative dielectric constant at a portion on the surface side of the semiconductor element 110 on the -Z direction side can be reduced. The cavity 140 covers the entire surfaces of the semiconductor elements 110 on the -Z direction side; however, of the surfaces of the semiconductor elements 110 in a plan view, the cavity 140 may be provided at least in a transistor region where a transistor is present or in an interconnect region where the redistribution interconnect 131 of the semiconductor element 110 is connected. The cavity 140 having a minimum size can reliably reduce the parasitic capacitance of the semiconductor element 110 and the redistribution interconnect 131, and both the strength of the redistribution layer 130 and the reduction in the parasitic capacitance can be achieved. In addition, when the cavity 140 is provided in the interconnect region in a plan view, the parasitic capacitance of the semiconductor element 110 and the redistribution interconnect 131 can be reliably reduced, and the propagation delay of a signal in the redistribution interconnect 131 can be inhibited.

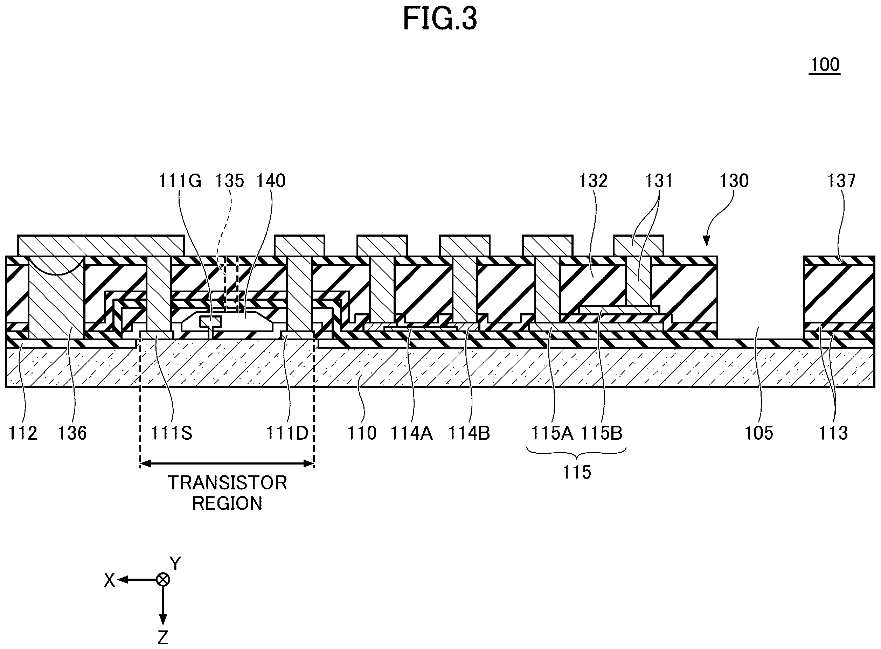

A region in which the redistribution interconnect 131 is connected to the surface of each semiconductor element 110 on the -Z direction side in FIG. 2 is the interconnect region. Since a transistor of the semiconductor element 110 is not illustrated in FIG. 2, illustration of the transistor region is omitted in FIG. 2. The transistor region and the interconnect region may overlap each other. The transistor region will be described later with reference to FIG. 3.

### <More Specific Configuration of Semiconductor Device 100>

FIG. 3 is a view illustrating an example of a more specific cross-sectional configuration of the semiconductor device 100. FIG. 3 further illustrates as a more specific configuration of the semiconductor device 100, a gate 111G, a source 111S, a drain 111D, an insulating layer 112, a protection layer 113, a resistor 114A, a terminal 114B, a MIM (Metal Insulator Metal) capacitor 115, a via 136, a protection layer 137, and a scribe line 105. The via 136 is an example of a metallic layer.

Among these components, the gate 111G, the source 111S, the drain 111D, the insulating layer 112, the protection layer 113, the resistor 114A, the terminal 114B, and the MIM capacitor 115 are components of the semiconductor element 110. The via 136 and the protection layer 137 are included in the redistribution layer 130. That is, the redistribution layer 130 includes the redistribution interconnect 131, the interlayer insulating film 132, the through hole 135, the via 136, and the protection layer 137. The scribe line 105 is a component of the semiconductor device 100.

The gate 111G, the source 111S, and the drain 111D are provided on the surface of the semiconductor element 110 on the -Z direction side, for example. In a plan view, a region where the gate 111G, the source 111S, and the drain 111D are provided is the transistor region. Note that the interval between the gate 111G and the drain 111D in the Y direction is longer than the interval between the gate 111G and the source 111S in the Y direction.

The cavity 140 illustrated in FIG. 3 surrounds the gate 111G, and the gate 111G is exposed in the cavity 140, for example. The parasitic capacitance at the gate 111G of the semiconductor element 110 and in the vicinity thereof can be reliably reduced, and the loss in the switching operation of the transistor can be reduced.

The cavity 140 is provided in the transistor region including a portion between the gate 111G and the source 111S and a portion between the gate 111G and the drain 111D in a plan view. In FIG. 3, the respective redistribution interconnects 131 connected to the source 111S and the drain 111D on the -Z direction side are not exposed in the cavity 140, but may be exposed. In the configuration illustrated in FIG. 3, the through hole 135 is indicated by a broken line because the through hole 135 is located at a position more toward the +Y direction side than the position in the cross section in the Y direction illustrated in FIG. 3, as an example.

The insulating layer 112 is an insulating layer formed by, for example, ion implantation on the surface of the semiconductor element 110 on the -Z direction side. The insulating layer 112 is formed in a portion other than the transistor region.

The protection layer 113 is an insulating layer provided on the -Z direction side of the redistribution layer 130, and is a surface protection layer that protects the surface of the semiconductor element 110. The protection layer 113 is made of SiN, for example. The protection layer 113 covers a contact portion of the base of the gate 111G with the semiconductor element 110, surfaces of the source 111S, the drain 111D, and the insulating layer 112 on the - Z direction side, the resistor 114A, the terminal 114B, the electrodes 115A and 115B of the MIM capacitor 115, and the like.

The resistor 114A, the terminal 114B, the MIM capacitor 115, and the via 136 are connected to the redistribution interconnects 131 as illustrated in FIG. 3 as an example. The protection layer 137 is made of SiN, for example, and covers the surface of the redistribution layer 130 on the -Z direction side. The scribe line 105 is provided at the end portion of the semiconductor device 100 in the -X direction.

As described above, in the semiconductor device 100, the cavity 140 is provided between the surface of the semiconductor element 110 on the redistribution layer 130 side and the interlayer insulating film 132 of the redistribution layer 130 in the transistor region in plan view. Thus, the parasitic capacitance of the semiconductor element 110 can be reduced in the transistor region. By reducing the parasitic capacitance of the semiconductor element 110, the transmission loss and transmission delay of a signal in the semiconductor element 110 can be reduced, and the operation characteristics of the semiconductor element 110 can be improved.

Note that, also in the transistor region, the protection layer 113 is provided on the surface of the semiconductor element 110 on the -Z direction side. The protection layer 113 is a SiN film that protects the surface of the semiconductor element 110. Since the protection layer 113 is much thinner than the interlayer insulating film 132, the parasitic capacitance due to the presence of the protection layer 113 is small.

Further, as illustrated in FIG. 2, the semiconductor device 100 has a configuration in which the heat sink 101 is directly connected to the surface of the semiconductor element 110 on the +Z direction side, and therefore, heat generated by the operation of the semiconductor element 110 can be released into the air through the heat sink 101. The temperature of the semiconductor element 110 is lowered, and thus, the distortion of the redistribution layer 130 can be reduced.

Further, since the redistribution layer 130 is supported by the mold resin 120 with respect to the semiconductor element 110, distortion due to heat generated by the semiconductor element 110 is prevented, and the semiconductor device 100 can stably operate for a long period of time.

The through hole 135 may penetrate a portion of the interlayer insulating film 132 other than the portion on the -Z direction side of the cavity 140. For example, a through hole that connects the through hole for forming the via 136 and the cavity 140 in the X direction may be formed. In this case, before the via 136 is formed, the cavity 140 is connected to the outside via the through hole extending in the X direction and the through hole for forming the via 136. When the via 136 is formed, only the inside of the through hole for forming the via 136 is filled with the metallic layer of the via 136, and the metallic layer is not formed in the through hole extending in the X direction. In this case, by forming the via 136, the metallic layer is formed in at least a part of the through hole that connects the cavity 140 to the outside of the redistribution layer 130, and thus it is possible to prevent moisture from entering the cavity 140. The via 136 may be formed in a cylindrical shape in the through hole penetrating the interlayer insulating film 132 in the Z direction to completely fill the through hole, or may be formed in a cylindrical shape along the inner surface of the through hole to not completely fill the through hole.

### <Method for Fabricating Semiconductor Device 100>

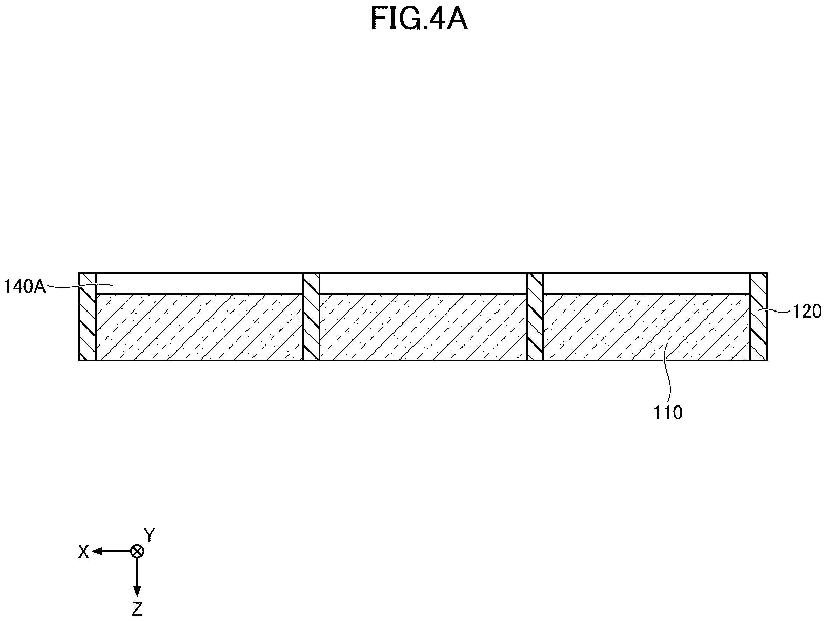

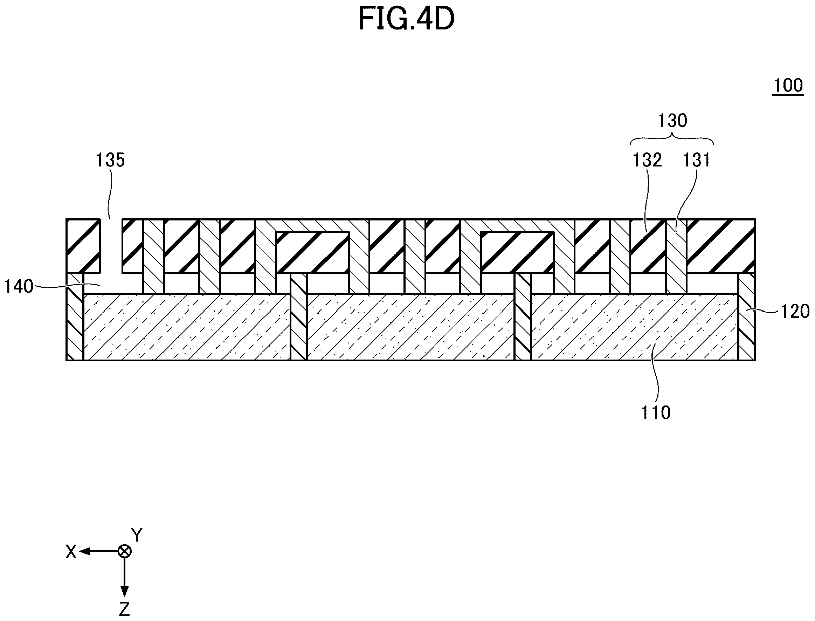

FIGS. 4A to 4D are views illustrating an example of a method for fabricating the semiconductor device 100.

First, as illustrated in FIG. 4A, a structure is prepared in which a laminate is obtained by forming the sacrificial film 140A on the surface of the semiconductor element 110 on the -Z direction side and side surfaces of the laminate are fixed by the mold resin 120. For example, the structure illustrated in FIG. 4A can be obtained by forming the sacrificial film 140A on a surface of a unsingulated semiconductor element 110 on the -Z direction side, then performing singulation, forming a mold resin on side surfaces of the singulated semiconductor elements using a mold, and polishing and planarizing the surfaces on the +Z direction side and the -Z direction side. The sacrificial film 140A may be made of a material that is decomposed by light such as ultraviolet rays. For example, when the semiconductor element 110 is a GaN semiconductor, the sacrificial film 140A may be made of a sacrificial film material corresponding to the GaN semiconductor. As the sacrificial film material corresponding to the GaN semiconductor, an organic layer that is decomposed by ultraviolet rays having wavelengths of 300 nm to 400 nm and includes oxygen-containing functional groups (carbonyl groups (CoS), carboxyl groups (COOH), hydroxyl groups (OH), and the like) may be used, for example. Examples of such an organic layer include methyl glutarimide, polymethyl methacrylate, polypropylene, and polycarbonate.

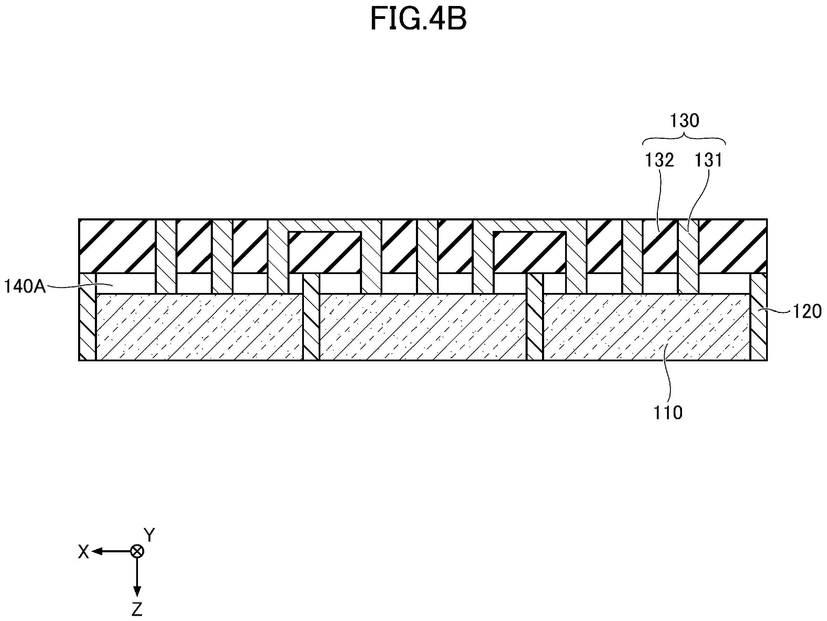

Next, as illustrated in FIG. 4B, the redistribution interconnect 131 and the interlayer insulating film 132 of the redistribution layer 130 are formed on the surface of the structure illustrated in FIG. 4A on the -Z direction side. The redistribution interconnect 131 is connected to a pad on the surface of the semiconductor element 110 on the -Z direction side after removing a part of the sacrificial film 140A by using a lithography technique. As an example, the redistribution interconnect 131 can be fabricated by forming a copper interconnect by a plating process. The interlayer insulating film 132 can be formed by forming a SiO₂ film, for example.

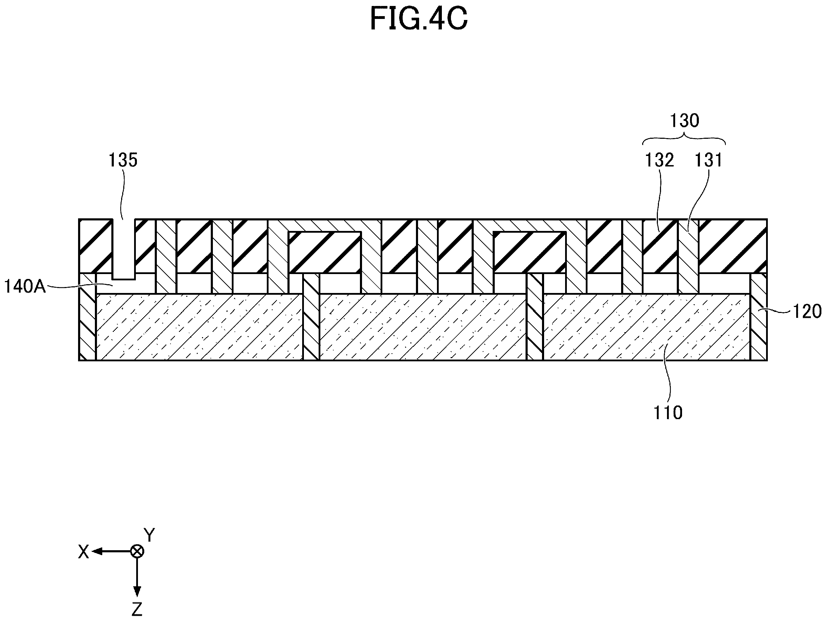

Next, as illustrated in FIG. 4B, the through hole 135 is formed in the interlayer insulating film 132 of the redistribution layer 130 illustrated in FIG. 4C. The through hole 135 may be formed by, for example, dry etching or wet etching using a photolithography technique. As the dry etching, ICP-RIE (Inductive Coupled Plasma Reactive Ion Etching) using a gas mixture of helium (He) and sulfurhexafluoride (SF₆), tetrafluoromethane (CF₄), or trifluoromethane (CHF₃) can be used. Among these, as an example, SF₆ is most preferable.

Next, when the sacrificial film 140A is removed by performing wet etching using an etching solution capable of removing the sacrificial film 140A through the through hole 135, the cavity 140 can be formed in the place where the sacrificial film 140A was present. As described above, dry etching using ultraviolet rays may be performed instead of wet etching. In this case, the reaction can be promoted when the redistribution layer 130 has the through hole 135, however, the redistribution layer 130 may not have the through hole 135.

### <Experimental Results>

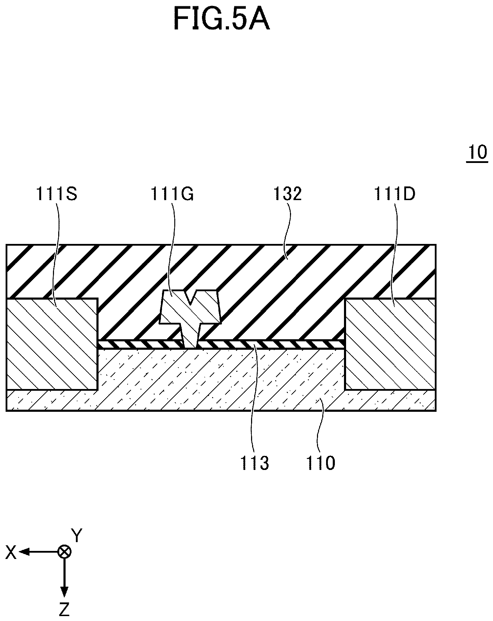

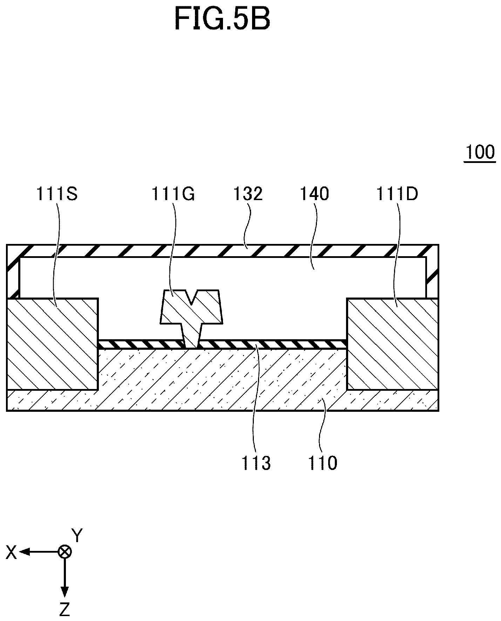

FIG. 5A is a view illustrating an example of a cross-sectional configuration of the semiconductor device 10 according to a comparative example. FIG. 5B is a view illustrating an example of a cross-sectional configuration of the semiconductor device 100 according to the embodiment. In FIG. 5B, a semiconductor element 110, a gate 111G, a source 111S, a drain 111D, an interlayer insulating film 132, a protection layer 113, and a cavity 140 are illustrated as components of the semiconductor device 100 according to the embodiment. The semiconductor device 10 according to the comparative example illustrated in FIG. 5A has a configuration in which the cavity 140 is removed from the semiconductor device 100 of the embodiment illustrated in FIG. 5B, and the gate 111G, the source 111S, the drain 111D, and the protection layer 113 are covered with the interlayer insulating film 132. Since the cavity 140 is not provided in the semiconductor device 10 according to the comparative example, the parasitic capacitance of the semiconductor element 110 is larger than that of the semiconductor device 100 of the embodiment.

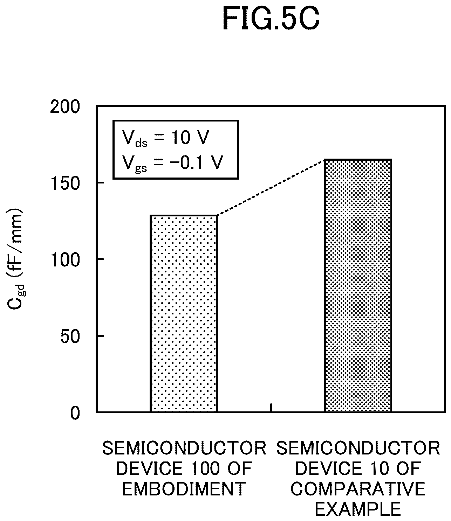

FIG. 5C is a graph illustrating examples of experimental results. The electrostatic capacitance C_{gd} between the gate 111G and the drain 111D of the semiconductor device 10 according to the comparative example illustrated in FIG. 5A and the electrostatic capacitance C_{gd} between the gate 111G and the drain 111D of the semiconductor device 100 of the embodiment illustrated in FIG. 5B were measured, and the results indicate that the electrostatic capacitance C_{gd} of the semiconductor device 100 of the embodiment was reduced by approximately 20%. The electrostatic capacitance C_{gd} of the semiconductor device 100 of the embodiment was approximately 130 (fF/mm), and the electrostatic capacitance C_{gd} between the gate 111G and the drain 111D of the semiconductor device 10 according to the comparative example was approximately 170 (fF/mm). The measurements were performed by setting the voltage V_{gs} between the gate 111G and the source 111S to -0.1 V, and setting the voltage V_{ds} between the drain 111D and the source 111S to 10 V. The results also indicate that the electrostatic capacitance C_{gs} between the gate 111G and the source 111S of the semiconductor device 100 of the embodiment was reduced by approximately 20%.

Through the experiments, the results indicate that the parasitic capacitance of the semiconductor element 110 can be reduced by providing the cavity 140 between the semiconductor element 110 and the redistribution layer 130. By reducing the parasitic capacitance of the semiconductor element 110, the transmission loss and transmission delay of signals in the semiconductor element 110 can be reduced, and excellent operation characteristics of the semiconductor element 110 capable of handling ultra-high frequencies can be obtained.

### <Modification>

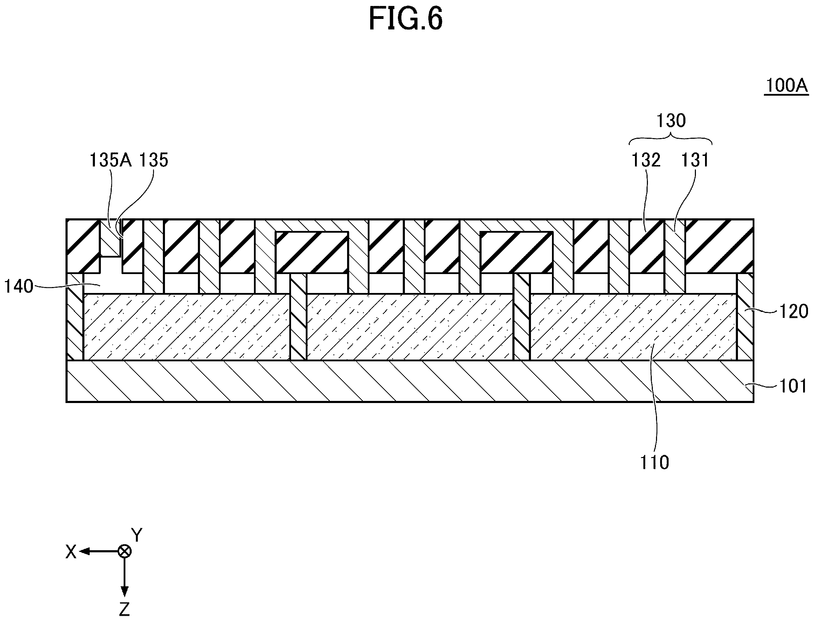

FIG. 6 is a view illustrating an example of a cross-sectional configuration of a semiconductor device 100A according to a modification of the embodiment. The semiconductor device 100A is different from the semiconductor device 100 illustrated in FIG. 2 in that a metallic layer 135A is provided inside the through hole 135. The metallic layer 135A may be included in the redistribution layer 130 and may be connected to the redistribution interconnect 131; however, the metallic layer 135A may be a dummy pattern that is not connected to the redistribution interconnect 131. The metallic layer 135A is made of copper, for example, as in the redistribution interconnect 131, and can be produced by a plating process.

The metallic layer 135A plugs the through hole 135. Therefore, it is possible to prevent moisture from entering the cavity 140 from the outside of the cavity 140. By plugging the through hole 135 with the metallic layer 135A, it is possible to more reliably prevent moisture from entering the cavity 140, and the semiconductor element 110 can operate more stably over a long period of time. As illustrated in FIG. 6, the metallic layer 135A need not necessarily plug the through hole 135 completely, and the metallic layer 135A may be provided in at least a part of the through hole 135. With such a configuration, it is possible to prevent moisture from entering the cavity 140, and the semiconductor element 110 can stably operate for a long period of time.

### <Effects>

A semiconductor device 100 includes a semiconductor element 110; a redistribution layer 130 provided on a first surface side of the semiconductor element 110, the redistribution layer 130 including a redistribution interconnect 131 connected to the semiconductor element 110 and an interlayer insulating film 132 covering the redistribution interconnect 131; and a cavity 140 provided between the first surface of the semiconductor element 110 and the redistribution layer 130. Therefore, the first surface (the surface on the -Z direction side) of the semiconductor element 110 faces the cavity 140, and the parasitic capacitance of the semiconductor element 110 can be reduced.

Therefore, the semiconductor device 100 with the reduced parasitic capacitance of the semiconductor element 110 can be provided.

The redistribution layer 130 may further include a through hole 135 that penetrates the interlayer insulating film 132 and communicates with the cavity 140. The cavity 140 can be formed by injecting an etching solution or the like through the through hole 135.

The cavity 140 may be provided in a transistor region where a transistor of the semiconductor element 110 is present or in an interconnect region where the redistribution interconnect 131 is connected to the semiconductor element 110 in a plan view. Thus, the parasitic capacitance of the semiconductor element 110 or the redistribution interconnect 131 can be reliably reduced by providing the cavity 140 having a minimum size, and both the strength of the redistribution layer 130 and the reduction in the parasitic capacitance can be achieved. In addition, when the cavity 140 is provided in the interconnect region in a plan view, the parasitic capacitance of the semiconductor element 110 and the redistribution interconnect 131 can be reliably reduced, and the transmission delay of a signal in the redistribution interconnect 131 can be prevented.

The cavity 140 may surround the gate 111G of the transistor. Therefore, the parasitic capacitance at the gate 111G of the semiconductor element 110 and in the vicinity thereof can be reliably reduced, and the loss in the switching operation of the transistor can be reduced.

Further, the semiconductor device 100 may include a plurality of semiconductor elements 110 and a plurality of cavities 140, and one cavity 140 may be provided in each semiconductor element 110. By providing one cavity 140 in each semiconductor element, the size of the cavity 140 can be minimized, and it is possible to achieve both securing the strength of the redistribution layer 130 and reduction in the parasitic capacitance.

The semiconductor device may include a plurality of semiconductor elements 110 and further include a mold resin 120 provided on side surfaces of the plurality of semiconductor elements 110, and the mold resin 120 may support the redistribution layer 130 with respect to the semiconductor elements 110. By providing the mold resin 120 on the side surface of each semiconductor element 110, the strength of the redistribution layer 130 can be secured in the configuration including the plurality of semiconductor elements 110.

In addition, the semiconductor device may further include a metallic layer 135A or a via 136 provided in at least a part of the through hole 135. By providing the metallic layer 135A or the via 136 in at least a part of the through hole 135, it is possible to prevent moisture from entering the cavity 140, and the semiconductor element 110 can stably operate for a long period of time. In particular, by plugging the through hole 135 with the metallic layer 135A or the via 136, it is possible to more reliably prevent moisture from entering the cavity 140, and the semiconductor element 110 can be operated more stably over a long period of time.

The semiconductor device 100 may further include a heat sink 101 provided on a second surface (surface on the +Z direction side) opposite to the first surface (surface on the -Z direction side) of the semiconductor element 110. This configuration enables cooling of the semiconductor element 110, and also achieves both stable operation of the semiconductor element 110 and prevention of distortion of the redistribution layer 130 due to heat.

A wireless communication device 200 includes a semiconductor element 110; a redistribution layer 130 provided on a first surface side of the semiconductor element 110, the redistribution layer 130 including a redistribution interconnect 131 connected to the semiconductor element 110 and an interlayer insulating film 132 covering the redistribution interconnect 131; a cavity 140 provided between the first surface of the semiconductor element 110 and the redistribution layer 130, a circuit board 210 provided opposite to the semiconductor element 110 with respect to the redistribution layer 130, the circuit board 210 being connected to the redistribution layer 130; and an antenna 220 provided on the circuit board 210. Thus, the first surface (the surface on the -Z direction side) of the semiconductor element 110 faces the cavity 140, and the parasitic capacitance of the semiconductor element 110 can be reduced.

Therefore, the wireless communication device 200 with the reduced parasitic capacitance of the semiconductor element 110 can be provided.

A method for fabricating a semiconductor device includes forming a sacrificial film 140A on a first surface of a semiconductor element 110; forming a redistribution layer 130 on the sacrificial film 140A, the redistribution layer 130 including a redistribution interconnect 131 connected to the semiconductor element 110 and an interlayer insulating film 132 covering the redistribution interconnect 131; and removing the sacrificial film 140A to form a cavity 140 between the first surface of the semiconductor element 110 and the redistribution layer 130. Thus, the first surface (the surface on the -Z direction side) of the semiconductor element 110 faces the cavity 140, and the parasitic capacitance of the semiconductor element 110 can be reduced.

Therefore, the method for fabricating a semiconductor device with the reduced parasitic capacitance of the semiconductor element 110 can be provided.

Although the semiconductor device, the wireless communication device, and the method for fabricating the semiconductor device according to the embodiment of the present disclosure have been described above, the present disclosure is not limited to the specifically disclosed embodiment, and various modifications and changes can be made without departing from the scope of the claims.

All examples and conditional language recited herein are intended for pedagogical purposes to aid the reader in understanding the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present invention have been described in detail, it should be understood that the various changes, substitutions, and alterations could be made hereto without departing from the spirit and scope of the invention.

### DESCRIPTION OF REFERENCE SYMBOLS

- 100,100A: Semiconductor device
- 101: Heat sink
- 105: Scribe line
- 110: Semiconductor device
- 111G: Gate
- 111S: Source
- 111D: Drain
- 112: Insulating layer
- 113: Protective layer
- 120: Mold resin
- 130: Redistribution layer (example of interconnect layer)
- 131: Redistribution (example of interconnect)
- 132: Interlayer insulating film (example of insulating layer)
- 133: Bump
- 135: Through hole
- 135A: Metallic layer
- 136: Via
- 140: Cavity
- 200: Wireless communication device
- 210: Circuit board
- 220: Antenna

## Claims

1. A semiconductor device (100, 100A) comprising:
a semiconductor element (110);
an interconnect layer (130) provided on a first surface side of the semiconductor element (110), the interconnect layer including an interconnect (131) connected to the semiconductor element and an insulating layer (132) covering the interconnect; and
a cavity (140) provided between the first surface of the semiconductor element and the interconnect layer.

2. The semiconductor device according to claim 1, wherein the interconnect layer (130) further includes a through hole (135) that penetrates the insulating layer (132) and communicates with the cavity (140).

3. The semiconductor device according to claim 1 or 2, wherein in a plan view, the cavity (140) is provided in a transistor region where a transistor of the semiconductor element is present or in an interconnect (131) region where the interconnect (131) is connected to the semiconductor element.

4. The semiconductor device according to claim 3, wherein the cavity (140) surrounds a gate (111G) of the transistor.

5. The semiconductor device according to claim 1, further comprising:
a plurality of semiconductor elements (110), the plurality of semiconductor elements including the semiconductor element; and
a plurality of cavities (140), the plurality of cavities including the cavity, wherein each of the plurality of semiconductor elements is provided with at least one cavity (140).

6. The semiconductor device according to claim 1, further comprising:
a plurality of semiconductor elements (110), the plurality of semiconductor elements including the semiconductor element; and
a mold resin (120) provided on side surfaces of each of the plurality of semiconductor elements, wherein the mold resin supports the interconnect layer (130) with respect to a corresponding one of the plurality of semiconductor elements.

7. The semiconductor device according to claim 6, wherein the cavity (140) is divided by the mold resin (120).

8. The semiconductor device according to claim 2, further comprising:
a metallic layer (135A) provided in at least a part of the through hole (135).

9. The semiconductor device according to claim 8, wherein the metallic layer (135A) plugs the through hole (135).

10. The semiconductor device according to claim 2, further comprising:
a plurality of semiconductor elements (110), the plurality of semiconductor elements including the semiconductor element, wherein each of the plurality of semiconductor elements is provided with one through hole (135).

11. The semiconductor device according to claim 2, further comprising:
a plurality of semiconductor elements (110), the plurality of semiconductor elements including the semiconductor element; and
a plurality of cavities (140), the plurality of cavities including the cavity, wherein each of the plurality of semiconductor elements is provided with one cavity, and
each of the plurality of cavities is provided with one through hole (135).

12. The semiconductor device according to claim 1, further comprising:
a heat sink (101) provided on a second surface of the semiconductor element (110) opposite to the first surface.

13. The semiconductor device according to any one of claims 1 to 10, wherein the interconnect (131) is a redistribution interconnect, the insulating layer (132) is an interlayer insulating film, and the interconnect layer (130) is a redistribution layer.

14. A wireless communication device (200) comprising:
a semiconductor element (110);
an interconnect layer (130) provided on a first surface side of the semiconductor element, the interconnect layer (130) including an interconnect (131) connected to the semiconductor element and an insulating layer (132) covering the interconnect;
a cavity (140) provided between the first surface of the semiconductor element and the interconnect layer;
a circuit board (210) provided opposite to the semiconductor element with respect to the interconnect layer (130), the circuit board being connected to the interconnect layer; and
an antenna (220) provided on the circuit board.

15. A method for fabricating a semiconductor device (100, 100A), the method comprising:
forming a sacrificial film (140A) on a first surface of a semiconductor element (110);
forming an interconnect layer (130) on the sacrificial film, the interconnect layer including an interconnect (131) connected to the semiconductor element and an insulating layer (132) covering the interconnect; and
removing the sacrificial film to form a cavity (140) between the first surface of the semiconductor element and the interconnect layer.
